# EUROPEAN PATENT APPLICATION

(11) **EP 0 922 564 A1**
(43) Date of publication of application: **16.06.1999**
(21) Application number: 97913445.9
(22) Date of filing: 26.11.1997
(51) Int. Cl.: B32B 15/08

(54) **METHOD AND APPARATUS FOR MANUFACTURING LAMINATE**

(30) Priority: 14.02.1997 JP 3078497
(71) Applicant: MATSUSHITA ELECTRIC WORKS, LTD., Kadoma-shi Osaka 571 (JP)
(72) Inventor: KAJITA, Susumu, Matsushita Electric Works, Ltd., Kadoma-shi Osaka 571 (JP); TOMISAKI, Takeshi, Matsushita Electric Works, Ltd., Kadoma-shi Osaka 571 (JP)
(74) Representative: Pellmann, Hans-Bernd, Dipl.-Ing.
(86) International application number: JP9704309
(87) International publication number: WO9835830

(57) **Abstract**

A laminated block formed by laminating sheet-like synthetic resin materials, metal interlayers at least some of which have a heat pipe provided incorporated therein and metal foils is formed in layers under pressure while the metal foil is being energized. The laminated block thus formed is then cooled under pressure by allowing the heat pipe-incorporated metal interlayers to cool. In this arrangement, the heat pipe can reduce the time required to cool the laminated block thus formed, making it possible to reduce the production lead time.

## Description

### Technical Field

The present invention relates to a process for the production of a laminate which comprises energizing a metal foil to generate a heat that facilitates laminating and an apparatus therefor.

### Background of the Invention

A laminate comprising a metal foil provided on the surface thereof is obtained by integrally laminating a metal foil and a sheet-like synthetic resin material. A laminate obtained from a copper foil or the like as a metal foil and a prepreg or the like as a sheet-like synthetic resin material is used for printed circuit board. Such a laminate is formed by a process which comprises laminating a metal foil and a sheet-like synthetic resin material such as prepreg, optionally laminating the laminate with an inner layer material or outer layer material, and then heating the laminate under pressure so that the synthetic resin contained in the sheet-like synthetic resin material is melted to undergo thermosetting or cold curing. The foregoing thermoforming under pressure is effected by means of a hot press or vacuum press using a heat source such as vapor and electric heater.

The foregoing hot pressing is carried out by means of a heated pressure plate. A laminate of members such as copper foil and sheet-like synthetic resin material is heated under pressure from both the upper and lower surfaces thereof by this pressure plate. In the foregoing vacuum pressing, a laminate of members is airtightly covered by a packing material. The air in the interior of the laminate is evacuated while a high temperature and pressure gas is being introduced into the surroundings of the laminate to effect forming. In order to effect laminating by this hot pressing or vacuum pressing, a plurality of sheet-like synthetic resin materials, metal foils or other members which constitute a laminate are combined to form a set of combined members. A plurality of sets of combined members are then laminated with a metal interlayer provided interposed therebetween to form a laminated block. The laminated block is then thermoformed under pressure to produce a plurality of sheets of laminates at the same time. This metal interlayer is used to secure the flatness of the various laminates. In general, a stainless steel plate is used as the metal interlayer.

When the foregoing laminated block formed by laminating combination members in layers is hot-pressed under pressure, it is heated from the upper and lower surfaces thereof by the pressure plate of the molding press. Therefore, the combination member close to the pressure plate and the combination member far from the pressure plate are heated at different temperatures due to the lag in heat conduction or the heat dissipation from the side of the laminated block. Such an ununiformity of heating temperature is undesirable because it causes the quality of the laminate to be varied widely. Accordingly, the number of combination members which can be laminated by hot pressing is limited.

On the other hand, vacuum pressing involves application of heat from the surroundings of the laminated block. Therefore, the temperature of the various combination members rise almost uniformly. However, vacuum pressing, too, is liable to temperature difference between the outer part and the central part of the laminated block due to the lag in heat conduction. This makes it difficult to form a large area laminate.

As an approach for overcoming these difficulties there is known a forming method as disclosed in British Patent 1,321,305. In this forming method, the foregoing combination members are laminated in layers with a metal plate provided interposed therebetween to form a laminated block. The metal plate is then energized to generate Joule heat so that a plurality of laminates are formed at the same time. In accordance with such a heating process as this forming method, various combination members laminated in layers can be heated directly by a metal plate. Accordingly, the laminate can be heated uniformly both in the vertical direction and in the horizontal direction. Thus, the quality of the laminate products are varied little, making it possible to solve the foregoing problems.

Further, JP-B-62-58903 (The term "JP-B" as used herein means an "examined Japanese patent publication") discloses a high pressure thermosetting method. In this method, a laminate of a metal foil and a thermoplastic resin film is supplied onto a metal roller via a feed roll. The metal foil is energized from the metal roller as an electrode to generate Joule heat. Thus, the metal foil acts as a heating element to effect high pressure thermosetting. The employment of the heating method using a metal foil makes the heating temperature uniform in the horizontal direction of the laminate and hence makes it possible to reduce the scattering of the in-plane quality of the laminate.

Moreover, Tokuhyou 7-508940 provides a forming method comprising in combination a method as disclosed in the above defined British Patent 1,321,305 and a method as disclosed in JP-B-62-58903. In this forming method, as a metal foil there is used a metal foil of continuous length. A sheet-like synthetic resin material is superimposed on the metal foil at a plurality of points along the longitudinal direction. The metal foil is folded at points between adjacent sheet-like synthetic resin materials to form a zigzag configuration. The various sheet-like synthetic resin materials are laminated in layers with an electrical insulating metal interlayer provided interposed therebetween to form a laminated block. This laminated block is then set in a molding press. The laminated block is then pressed while the metal foil is being energized to generate heat. In this manner, the laminated block is thermoformed under pressure. Thus, the sheet-like synthetic resin material can be directly heated by the laminated metal foils. Accordingly, the heating temperature is made uniform both in the vertical direction and in the horizontal direction, making it possible to produce laminates with little quality variation in layers at a good productivity.

This forming method involving the heating using a metal foil allows the uniformalization of heating temperature at the step of thermoforming under pressure. However, this forming method is disadvantageous in that the laminate thus thermoformed under pressure must then be allowed to cool under pressure as in the conventional hot pressing method, requiring a prolonged production lead time.

Let us further explain this forming method with reference to the case where as the sheet-like synthetic resin material there is used a laminate formed by a prepreg such as epoxy resin-impregnated glass cloth prepared by impregnating a substrate such as glass cloth with a thermosetting resin and then drying the material. When the laminate thermoformed under pressure is allowed to cool, the surface of the metal foil looks embossed with the pattern of the weave in glass cloth as substrate, particularly the intersection of yarn made of bundle of glass fibers, to increase the surface roughness of the laminate because the thermosetting resin greatly shrinks unless the laminate is kept under pressure until the temperature of the laminate is lowered to not higher than the glass transition temperature of the thermosetting resin. For example, if the laminate thermoformed under pressure is allowed to cool under no pressure, it exhibits a surface roughness Rmax of from 4 to 7 µm aslant the yarn as determined by means of feeler type surface roughness meter. This makes it difficult to form a fine circuit pattern on the laminate in the process for processing the laminate into a printed circuit board by etching or other circuit forming methods. On the contrary, if the laminate thermoformed under pressure is allowed to cool under pressure, it exhibits a surface roughness Rmax of not more than 1 µm. Accordingly, it is necessary that the laminate thermoformed under pressure be allowed to cool under pressure by molding press.

However, it takes much time for the laminate thermoformed under pressure to cool under pressure because the stack of laminates has a very small exposed surface area, requiring a prolonged production lead time. The laminate can be forcedly cooled by blowing cooling air against the laminate on the periphery thereof from an electric fan. Also in this method, however, heat is released only from the periphery of the laminate. Thus, it takes much time to cool the interior of the multiple stack of laminates. Accordingly, this method can exert little or no effect of reducing the production lead time.

The foregoing method which comprises energizing a metal foil to generate Joule heat that heats a stack of laminates so that these laminates are simultaneously formed is disadvantageous in that the amount of electric current flowing through the metal foil must be controlled according to the measurements of the temperature in the laminated block to control the amount of heat generated by the metal foil. Thus, it is a common practice to insert a thermocouple into the laminated block for the purpose of measuring the temperature in the laminated block.

However, if the laminated block is formed with a thermocouple inserted therein, the laminate formed at the point where the thermocouple is present is embossed with the shape of the thermocouple and thus is of no use, reducing the productivity of the laminate. A laminate formed with a thermocouple incorporated therein can be used as a dummy which is incorporated in the laminated block. However, this method leaves something to be desired. In other words, the space which can be used to produce laminates is reduced by that for the dummy laminate, reducing the productivity.

The present invention has been worked out under these circumstances. An object of the present invention is to provide a production process which can produce a laminate having a uniform quality as well as enhance the cooling efficiency while keeping the surface roughness of the laminate small to reduce the production lead time and enhance the productivity.

### Disclosure of the Invention

(1) A process for the production of a laminate according to the present invention comprises folding a metal foil 1 sandwiched between a sheet-like synthetic resin material 2 and a metal interlayer 4 having an electrical insulating surface at the ends thereof to form a laminated block of said sheet-like synthetic material 2, said metal interlayer 4 and said metal foil 1, a plurality of said metal foils 1 being connected to each other between adjacent sheet-like synthetic resin materials arranged with said metal interlayer 4 provided interposed therebetween, pressing said laminated block 5 while said metal foil 1 is being energized to generate heat, and then cooling said laminated block 5 thus formed under pressure to form a laminate, characterized in that a heat pipe 6 is provided incorporated in at least some of said metal interlayers 4 and said metal interlayers 4 having said heat pipe 6 provided incorporated therein are laminated with said metal foil 1 in such a manner that the edge thereof protrudes from said laminated block 5, whereby heat is released from said protruding metal interlayers 4 to allow said laminated block 5 thus formed to cool.
(2) The cooling of the laminated block in Clause 1 can be carried out by forced cooling of said metal interlayers having a heat pipe provided incorporated therein.
(3) The cooling of the laminated block in Clause 1 can be carried out by forced cooling of radiating fins provided on said metal interlayers having a heat pipe provided incorporated therein.
(4) The cooling of the laminated block in Clause 1 can be carried out by water cooling of said metal interlayers having a heat pipe provided incorporated therein.
(5) The cooling of the laminated block in Clause 1 can be carried out by water cooling by a water-cooled jacket attached to the radiating portion of said metal interlayers having a heat pipe provided incorporated therein.
(6) An apparatus for the production of a laminate according to the present invention comprises a laminated block formed by folding a metal foil 1 sandwiched between a sheet-like synthetic resin material 2 and a metal interlayer 4 having an electrical insulating surface at the ends thereof to form a laminated block of said sheet-like synthetic material 2, said metal interlayer 4 and said metal foil 1, a plurality of said metal foils 1 being connected to each other between adjacent sheet-like synthetic resin materials arranged with said metal interlayer 4 provided interposed therebetween, an energizing heating device for energizing said metal foil to cause said metal foil to generate heat, and a molding press for pressing said laminated block, characterized in that at least some of said metal interlayers have a heat pipe provided incorporated therein and said metal interlayers having a heat pipe provided incorporated therein are large enough to protrude from said laminated block at the edge thereof.
(7) The metal interlayers having a heat pipe provided incorporated therein defined in Clause (6) can have radiating fins provided on the protruding portion thereof.
(8) The metal interlayers having a heat pipe provided incorporated therein defined in Clause (6) can have a plurality of rod heat pipes embedded in parallel to each other therein.
(9) The metal interlayers having a heat pipe provided incorporated therein defined in Clause (6) can have a flat heat pipe embedded therein.
(10) In one of Clauses (6) to (9), a temperature measuring instrument for measuring the temperature in the metal interlayers having a heat pipe provided incorporated therein can be provided.

### Brief Description of the Drawings

Fig. 1 is a schematic front view illustrating an embodiment of the present invention;
Fig. 2 is a schematic perspective view illustrating an embodiment of the laminated block according to the present invention; and
Fig. 3 is a perspective view illustrating an embodiment of the metal interlayer having a heat pipe incorporated therein according to the present invention.

### Best Embodiment of Implication of the Invention

Embodiments of the present invention will be described hereinafter.

In the present invention, as the sheet-like synthetic resin material 2 there may be used a stack of a plurality of prepregs prepared by impregnating a substrate such as glass cloth with a thermosetting resin and then drying the material or a laminate of such a prepreg with an inner layer plate or outer layer plate having a circuit formed thereon. In the present invention, as the metal foil 1 there may be used a copper foil of continuous length. In the present embodiment, two sheets of metal foils 1 are used.

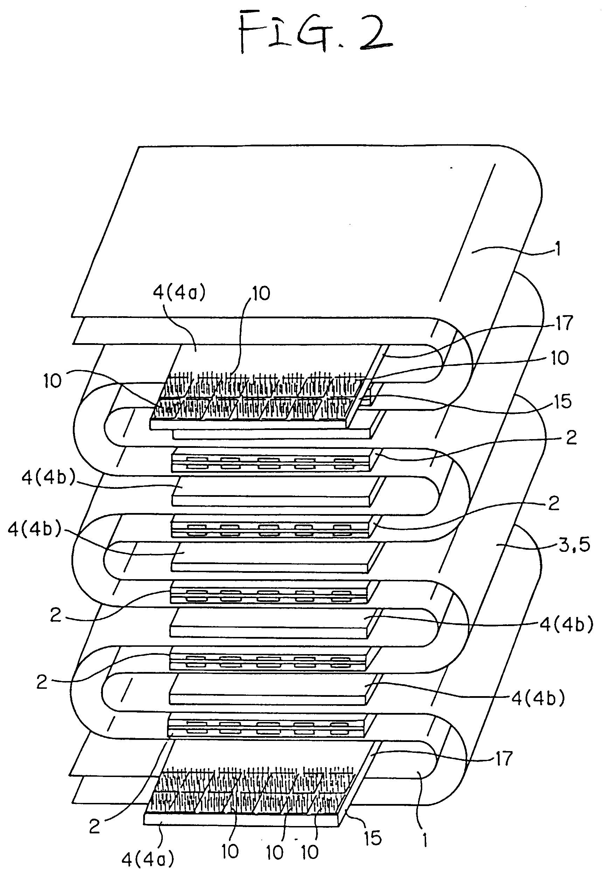

The sheet-like synthetic resin material 2 is provided interposed between two sheets of the metal foils 1 at a plurality of points along the longitudinal direction to form a laminated combination material 3. The metal foil 2 is then folded at points between adjacent sheet-like synthetic resin materials 2 with the metal interlayer 4 provided interposed between the opposing upper and lower metal foils 2 in such an arrangement that the adjacent metal foils 1 are not brought into contact with each other so that the laminated combination material 3 is bent zigzag. Thus, various sheet-like synthetic resin materials 2 are laminated in layers to form a laminated block 5 as shown in Fig. 2.

In the foregoing embodiment, as the metal foil 1 there is used two sheets of metal foils of continuous length. However, other forms of metal foils may be used. For example, a sheet of metal foil of continuous length may be used to connect all the layers.

The laminated block 5 may be formed free of laminated combination material 3. In this alternate method, a sheet of a sheet-like synthetic resin material 2 is superimposed on a sheet of a metal foil 1. The metal foil 1 is then folded back at one end of the sheet-like synthetic resin material 2 so that the free length of the metal foil 1 is superimposed on the sheet-like synthetic resin material 2. A metal interlayer 4 is then superimposed on the metal foil 1. The metal foil 1 is then folded back at one end of the metal interlayer 4 so that the free length of the metal foil 1 is superimposed on the metal interlayer 4. Another sheet of the sheet-like synthetic resin material 2 is then superimposed on the metal foil 1. This laminating procedure is repeated from one pressure disc 16 towards the other pressure disc 16 of the molding press 8 to form a laminated block 5.

The metal interlayer 4 is formed by a material which is electrically insulating at least on the surface thereof. Some of the metal interlayers 4 have a heat pipe 6 provided incorporated therein. The metal interlayer 4a having a heat pipe 6 provided incorporated therein is laminated with the metal foil 1 in such an arrangement that it protrudes from the laminated block 5 at the edge thereof. It is not necessary that all of the metal interlayers 4 have a heat pipe 6 provided incorporated therein. As the other metal interlayer 4b there may be used one prepared by anodizing the surface of a metal plate such as aluminum plate to form a hard anodized film thereon, and then impregnating the anodized film with polyethylene tetrafluoride to form an electrical insulating film having a thickness of from 30 to 40 µm thereon.

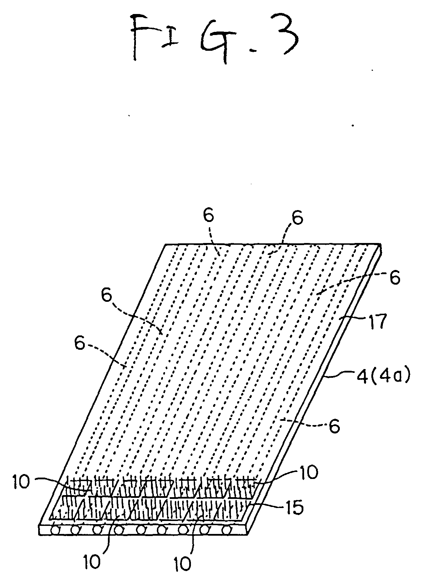

The metal interlayer 4a having a heat pipe 6 provided incorporated therein may have a plurality of heat pipes 6 embedded in parallel to each other in a metal plate such as aluminum plate as shown in Fig. 3. Alternatively, a flat heat pipe such as an extremely thin plate heat pipe (TPHP) produced by Acronics Corp. may be employed which comprises a flat metal plate soldered to a metal plate patterned with a zigzag groove on one surface thereof filled with an operating fluid. All these metal interlayers have an electrical insulating film formed thereon to have electrical insulating properties as the foregoing metal interlayer 4b. One edge of the metal interlayer 4a acts as a radiating portion 15. The various heat pipes 6 are disposed in such an arrangement that one end thereof is on the radiating portion 15 as shown in Fig. 3. Further, the radiating portion 15 preferably comprises radiating fins 10 provided thereon to enhance heat radiating properties thereof.

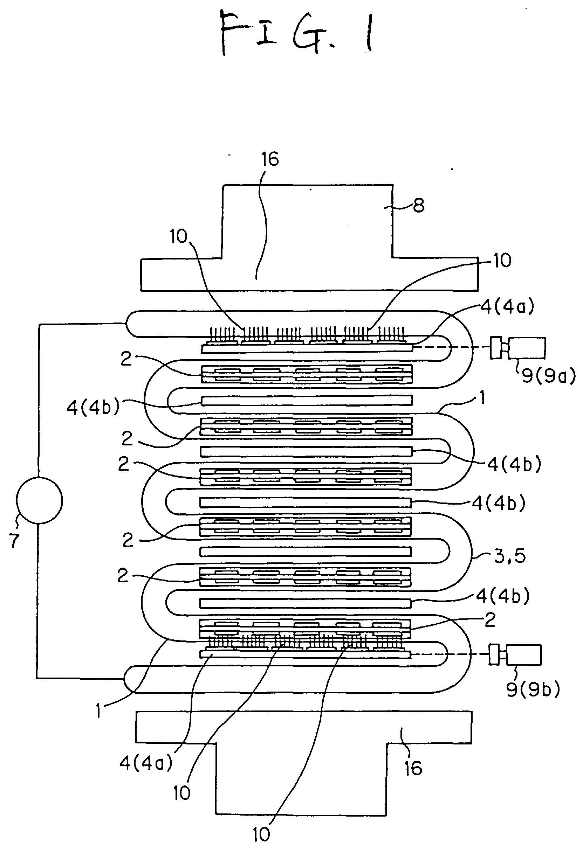

In the embodiment shown in Fig. 2, as each of the uppermost and lowermost metal interlayers 4 there is used a metal interlayer 4a having a heat pipe 6 provided incorporated therein. As each of the other metal interlayers there is used a metal interlayer 4b free of heat pipe 6. The metal interlayer 4a having a heat pipe 6 provided incorporated therein is disposed protruding from the laminated block 5 at the radiating portion 15. The laminated block 5 formed as shown in Fig. 2 is then set between pressure discs 16, 16 of the molding press 8 as shown in Fig. 1. An energizing heating device 7 is then connected to both the ends of the metal foil 1. Under these conditions, forming is then effected. As the molding press 8 there may be used a vacuum laminating press for pressing in a vacuum chamber. In operation, the air in the vacuum chamber is evacuated to 10·torr. Under these conditions, the two sheets of metal foils 1 are energized with direct current from the power supply of the energizing heating device 7 to generate heat as an electric resistor while the laminated block 5 is being pressed under an upward and downward pressure of 10 kgf/cm² from the pressure discs 16, 16, respectively. In this manner, the various sheet-like synthetic resin materials 2 can be directly heated by the metal foil 1 which is in contact therewith during forming. Accordingly, the sheet-like synthetic resin material 2 can be heated uniformly both in the vertical direction and in the horizontal direction, making it possible to produce laminates with little quality variation in layers at a good productivity.

The heat pipe 6 has a heat conductivity as high as hundreds of times that of metal and a good response. The metal interlayer 4a having such a heat pipe 6 provided incorporated therein is inserted into the laminated block 5. In this arrangement, the metal interlayer 4a acts as a heat-receiving portion 17 at the area thereof in contact with the metal foil 1. The heat received from the laminated block 5 by the heat-receiving portion 17 is then rapidly transmitted to the radiating portion 15 through the heat pipe 6. This makes the difference in temperature between the heat-receiving portion 17 and the radiating portion 15 of the metal interlayer 4a very small. If a metal interlayer 4b prepared from an ordinary aluminum plate or the like is used in this arrangement, the difference in temperature between the heat-receiving portion of the metal interlayer 4b inserted into the laminated block 5 and brought into contact with the metal foil 1 and the radiating portion of the metal interlayer 4b protruding from the laminated block 5 is great. This is because the aluminum plate has a far lower heat conductivity and a lower heat response than the heat pipe 6, making it impossible to allow sufficient transmission of heat from the heat-receiving portion to the radiating portion.

As mentioned above, the difference in temperature between the heat-receiving portion 17 and the radiating portion 15 of the metal interlayer 4a having a heat pipe 6 provided incorporated therein is very small. Thus, by measuring the temperature of the radiating portion 15 protruding from the laminated block 5, the heating temperature of the laminated block 5 developed by the heat generation of the metal foil 1 can be detected. Accordingly, the amount of electric current flowing through the metal foil 1 from the energizing heating device 7 can be controlled on the basis of the measurements of temperature of the radiating portion 15 of the metal interlayer 4a to control the heat generation from the metal foil 1 and hence the heating temperature of the laminated block 5. Thus, forming can be effected while the heating temperature is being controlled to a predetermined value, e.g., 180°C. The difference in temperature between the heat-receiving portion 17 and the radiating portion 15 of the metal interlayer 4a is very small but not zero because the radiating portion 15 radiates heat. In general, this temperature difference offers no problem. However, if it is desired to strictly control the heating temperature, the relationship between the temperature of the radiating portion 15 determined by a radiation thermometer or the like and the temperature of the heat-receiving portion 17 determined by a thermocouple or the like may be established. The accurate temperature of the heat-receiving portion 17 can be detected from the radiating portion 15 on the basis of this relationship.

The temperature of the radiating portion 15 of the metal interlayer 4a having a heat pipe 6 provided incorporated therein can be measured by means of a temperature measuring instrument such as radiation thermometer 9a or thermocouple as shown in Fig. 1. Since the radiating portion 15 protrudes from the laminated block 5, the temperature in the laminated block 5 can be detected outside the laminated block 5. Accordingly, it is not necessary to insert a thermocouple into the laminated block 5 or form the laminate block 5 with a thermocouple-incorporated dummy laminating plate provided incorporated therein as in the conventional production processes, making it possible to prevent the reduction of the productivity of the laminate.

As mentioned above, the laminated block 5 is thermoformed under pressure while the metal foil 1 is being energized by the energizing heating device 7. Thereafter, the energization of the metal foil 1 is suspended to allow the laminated block 5 thus thermoformed to cool while being kept under pressure by the molding press 8. In the cooling process, the metal interlayer 4a having a heat pipe 6 provided incorporated therein receives heat from the laminated block 5 at the heat-receiving portion 15 inserted into the laminated block 5 and then rapidly transmits the heat through the heat pipe 6 to the radiating portion 15 from which it is radiated. In this manner, the cooling of the laminated block 5 thus formed can be carried out in a short period of time. Radiating fins 10, if provided on the radiating portion 15, can enhance the radiation efficiency that increases the cooling effect, making it possible to further reduce the cooling time. Further, by forcedly cooling the radiating fins 10 by means of an electric fan, the radiation efficiency can be further enhanced, making it possible to further increase the cooling effect. Alternatively, a water-cooled jacket may be attached to the radiating portion 15 to effect water cooling.

If the laminated block 5 thermoformed under pressure is allowed to cool free from the metal interlayer 4a having a heat pipe 6 provided incorporated therein under pressure, it takes 5 hours for the laminated block 5 to lower its temperature from 180°C to 100°C, which is lower than the glass transition temperature thereof. If the laminated block 5 is forcedly cooled by blowing air against the periphery of the laminated block 5 from an electric fan free from the metal interlayer 4a having a heat pipe 6 provided incorporated therein under pressure, it takes 1 hour for the laminated block 5 to lower its temperature from 180°C to 100°C. On the other hand, if the laminated block 5 is forcedly cooled by blowing air against the radiating fins 10 from an electric fan with the metal interlayer 4a having a heat pipe 6 provided incorporated therein inserted into the laminated block 5 as in the present invention, it takes 10 minutes for the laminated block 5 to lower its temperature from 180°C to 100°C, making it possible to drastically reduce the production lead time.

By measuring the temperature of the radiating portion 15 of the metal interlayer 4a having a heat pipe 6 provided incorporated therein during the cooling of the laminated block 5 thus thermoformed, the temperature drop in the laminated block 5 can be detected. Accordingly, by measuring the temperature of the radiating portion 15 of the metal interlayer 4a, the operation can be controlled such that the molding press 8 is opened to withdraw the laminated block 5 when the temperature of the laminated block 5 is detected to drop to the predetermined value.

By cutting and separating these laminated blocks 5 thus withdrawn from each other at the folded point of the metal foil 1, laminates each having a sheet-like synthetic resin material 2 integrally laminated with a metal foil 1 on both the surfaces thereof can be obtained. In the present invention, the laminated block 5 is cooled under pressure as mentioned above. The resulting laminate exhibits a surface roughness Rmax of not more than 1 µm. Thus, a fine circuit can be formed on the laminate according to the present invention.

### Industrial Applicability

As mentioned above, the process for the production of a laminate according to the present invention comprises folding a metal foil sandwiched between a sheet-like synthetic resin material and a metal interlayer having an electrical insulating surface at the ends thereof to form a laminated block of said sheet-like synthetic material, said metal interlayer and said metal foil, a plurality of said metal foils being connected to each other between adjacent sheet-like synthetic resin materials arranged with said metal interlayer provided interposed therebetween, pressing said laminated block while said metal foil is being energized to generate heat, and then cooling said laminated block thus formed under pressure to form a laminate. Thus, the various sheet-like synthetic resin materials can be directly heated by the metal foil. The sheet-like synthetic resin material can be heated uniformly both in the vertical direction and in the horizontal direction, making it possible to produce laminates with little quality variation in layers at a good productivity. Further, by cooling the laminated block under pressure, a laminate having a small surface roughness can be obtained. Moreover, some of the metal interlayers can have a heat pipe provided incorporated therein. The laminated block thus thermoformed can be cooled by allowing these heat pipe-incorporated metal interlayers to cool. In this arrangement, heat in the laminated block can be rapidly transmitted through the heat pipe and then radiated. The time required to cool the laminated block thus thermoformed can be reduced, making it possible to reduce the production lead time.

Further, a temperature measuring instrument for measuring the temperature of the metal interlayer having a heat pipe provided incorporated therein can be provided. By thus measuring the temperature of the metal interlayer, the temperature of the laminated block can be detected, eliminating the necessity of inserting a thermocouple for temperature measurement into the laminated block. Thus, no laminates can be wasted, making it possible to prevent the reduction of the productivity of the laminate.

Further, the metal interlayer having a heat pipe provided incorporated therein can be disposed protruding from the laminated block at the edge thereof. The protruding edge of the metal interlayer can have radiating fins provided thereon. These radiating fins provide a high radiation efficiency that can further reduce the cooling time, making it possible to further reduce the production lead time.

## Claims

1. A process for the production of a laminate comprising: folding a metal foil sandwiched between a sheet-like synthetic resin material and a metal interlayer having an electrical insulating surface at the ends thereof to form a laminated block of said sheet-like synthetic material, said metal interlayer and said metal foil, a plurality of said metal foils being connected to each other between adjacent sheet-like synthetic resin materials arranged with said metal interlayer provided interposed therebetween; pressing said laminated block while said metal foil is being energized to generate heat; and cooling said laminated block thus formed under pressure to form a laminate; characterized in that a heat pipe is provided incorporated in at least some of said metal interlayers and said metal interlayers having said heat pipe provided incorporated therein are laminated with said metal foil in such a manner that the edge thereof protrudes from said laminated block, whereby heat is released from said protruding metal interlayers to allow said laminated block thus formed to cool.

2. The process for the production of a laminate according to Claim 1, wherein the cooling of said laminated block is carried out by forced cooling of said metal interlayers having a heat pipe provided incorporated therein.

3. The process for the production of a laminate according to Claim 1, wherein the cooling of said laminated block is carried out by forced cooling of radiating fins provided on said metal interlayers having a heat pipe provided incorporated therein.

4. The process for the production of a laminate according to Claim 1, wherein the cooling of said laminated block is carried out by water cooling of said metal interlayers having a heat pipe provided incorporated therein.

5. The process for the production of a laminate according to Claim 1, wherein the cooling of said laminated block is carried out by water cooling by a water-cooled jacket attached to the radiating portion of said metal interlayers having a heat pipe provided incorporated therein.

6. An apparatus for the production of a laminate comprising: a laminated block formed by folding a metal foil sandwiched between a sheet-like synthetic resin material and a metal interlayer having an electrical insulating surface at the ends thereof to form a laminated block of said sheet-like synthetic material, said metal interlayer and said metal foil; a plurality of said metal foils being connected to each other between adjacent sheet-like synthetic resin materials arranged with said metal interlayer provided interposed therebetween; an energizing heating device for energizing said metal foil to cause said metal foil to generate heat; and a molding press for pressing said laminated block; characterized in that at least some of said metal interlayers have a heat pipe provided incorporated therein and said metal interlayers having a heat pipe provided incorporated therein are large enough to protrude from said laminated block at the edge thereof.

7. The apparatus for the production of a laminate according to Claim 6, wherein metal interlayers having a heat pipe provided incorporated therein have radiating fins provided on the protruding portion thereof.

8. The apparatus for the production of a laminate according to Claim 6, wherein metal interlayers having a heat pipe provided incorporated therein have a plurality of rod heat pipes embedded in parallel to each other therein.

9. The apparatus for the production of a laminate according to Claim 6, wherein metal interlayers having a heat pipe provided incorporated therein have a flat heat pipe embedded therein.

10. The apparatus for the production of a laminate according to any one of Claims 6 to 9, comprising a temperature measuring instrument for measuring the temperature in the metal interlayers having a heat pipe provided incorporated therein.
